# FASCICULE DE BREVET EUROPEEN

(11) **EP 0 765 497 B1**
(45) Date de publication et mention de la délivrance du brevet: **06.05.1998**
(21) Numéro de dépôt: 95923371.9
(22) Date de dépôt: 12.06.1995
(51) Int. Cl.: G06F 11/10, G11C 29/00

(54) **CORRECTION D'ERREURS DANS UNE MEMOIRE**
KORREKTUR VON SPEICHERFEHLERN
MEMORY ERROR CORRECTION

(30) Priorité: 14.06.1994 FR 9407497
(43) Date de publication de la demande: 02.04.1997
(73) Titulaire: CENTRE NATIONAL DE LA RECHERCHE SCIENTIFIQUE, 75007 Paris (FR)
(72) Inventeur: NICOLAIDIS, Michael, F-38120 Grenoble (FR); VARGAS, Fabian, F-38000 Grenoble (FR)
(74) Mandataire: de Beaumont, Michel
(86) Numéro de dépôt international: FR9500767
(87) Numéro de publication internationale: WO9534858

(56) Documents cités:
- EP-A- 0 307 958
- US-A- 3 746 981
- IEEE JOURNAL OF SOLID-STATE CIRCUITS, vol.27, no.3, Mars 1992 pages 425 - 428, XP000295899 MALY AND PATYRA 'Built-in Current Testing'

## Description

La présente invention concerne la correction d'erreurs survenant dans une mémoire statique à la suite de perturbations, telles que des bombardements d'ions lourds.

Des équipements électroniques peuvent, dans certaines conditions, notamment dans l'espace, être soumis à des bombardements de particules, en particulier des ions lourds. Lorsque la région de drain d'un transistor MOS polarisé d'une manière déterminée est traversée par un ion lourd, le transistor MOS génère une impulsion parasite sur son drain. Un tel phénomène de perturbation, couramment appelé phénomène de "upset", peut entraîner des effets gênants, notamment changer l'état d'une cellule mémoire.

On a déjà cherché dans l'art antérieur à résoudre ce problème et à réaliser des cellules de mémoire statique insensibles aux radiations (durcies). Une première approche consiste à prévoir une architecture de cellule mémoire telle qu'une perturbation sur un noeud sensible n'entraîne pas de basculement de cette cellule. Pour cela, un article de IEEE Transactions on Nuclear Science, volume 35, N° 6, décembre 1988, pages 1682 à 1687, "An SEU-Hardened CMOS Data Latch", propose d'utiliser une cellule mémoire entourée d'un réseau de transistors MOS qui a pour rôle de rétablir la donnée modifiée par un phénomène de perturbation. Cette solution entraîne une augmentation notable de la complexité de chaque cellule mémoire.

Une autre approche consiste à rallonger chaque mot stocké dans une mémoire d'un code de contrôle d'erreur. Ainsi, à chaque fois qu'un mot est lu dans la mémoire, on lit également son code de contrôle. Si le code de contrôle est un code détecteur d'erreur, il indique seulement, le cas échéant, que le mot comporte des bits erronés. Si le code de contrôle est un code correcteur, on peut en outre corriger un certain nombre de bits erronés du mot. Toutefois, pour ne pas augmenter significativement la capacité mémoire et la taille des bus d'accès à cette mémoire, le code de contrôle doit avoir un nombre de bits limité, ce qui diminue son efficacité. Par exemple, pour pouvoir corriger un seul bit erroné d'un mot de 8 bits, il faut un code correcteur de 4 bits (au moins 3 bits pour corriger une erreur dans le mot et un bit pour déceler des erreurs dans le code correcteur lui-même). Un exemple de tel code est le code de Hamming. Un bit supplémentaire du code correcteur, par exemple un bit de parité, ne permettra pas de corriger une deuxième erreur mais permettra d'indiquer de manière fiable, en combinaison avec les trois autres bits du code, qu'il y a une erreur corrigible ou deux erreurs. Ce dernier type de code, code correcteur d'erreurs simples et de détection d'erreurs doubles, est couramment employé.

On utilise parfois aussi des codes correcteurs dits bidimensionnels, décrits dans l'ouvrage "Testing semiconductor Memories, Theory and Practice", par A.J. van de Goor, éditions John Wiley & Sons, 1991. Ce codage consiste à prévoir un code de contrôle, souvent de parité, pour chaque mot et pour chaque colonne de cellules d'une mémoire. Ainsi, on localise une erreur à l'intersection d'un mot et d'une colonne indiqués par des parités respectives erronées. Ce codage a l'inconvénient de notablement réduire la rapidité des écritures dans la mémoire, puisqu'il faut recalculer les parités des colonnes à chaque écriture.

Un objet de la présente invention est de prévoir une structure de mémoire statique permettant de corriger un nombre élevé d'erreurs à l'aide de codes de contrôle réduits, sans pour autant affecter la cadence d'accès à la mémoire.

Pour atteindre cet objet, la présente invention prévoit une mémoire statique comme revendiquée dans la revendication 1. Il est connu en soi, de l'article IEEE JOURNAL OF SOLID-STATE CIRCUITS, vol. 27, no. 3, Mars 1992 pages 425 - 428, XP000295899 MALY and PATYRA 'Built-in Current Testing', de tester le courant d'alimentation d'un circuit intégré pour tester la fonctionalité.

Selon un mode de réalisation de la présente invention, la mémoire comprend des moyens pour augmenter le seuil de chaque détecteur pendant un accès à la mémoire.

Selon un mode de réalisation de la présente invention, chaque colonne comprend deux lignes d'alimentation spécifiques reliées à deux lignes d'alimentation générale de la mémoire par l'intermédiaire de détecteurs de courant respectifs.

Selon un mode de réalisation de la présente invention, le code de contrôle est un bit de parité.

Ces objets, caractéristiques et avantages ainsi que d'autres de la présente invention seront exposés plus en détail dans la description suivante de modes de réalisation particuliers faite à titre non-limitatif à l'aide des figures jointes parmi lesquelles :
la figure 1 représente schématiquement un mode de réalisation d'architecture de mémoire statique selon l'invention ;
la figure 2 représente une cellule de mémoire statique classique ; et
la figure 3 représente un mode de réalisation de détecteurs de courant pouvant être utilisés dans l'architecture de la figure 1.

Selon l'invention, on a constaté qu'une erreur due à une perturbation, telle qu'un bombardement d'ions lourds, entraîne une consommation de courant momentanée due au basculement de la cellule perturbée. L'invention propose de détecter la survenue anormale d'une telle consommation de courant dans chaque colonne de cellules d'une mémoire. L'erreur est ensuite localisée dans une rangée de cellules grâce à un code de contrôle qui peut être particulièrement simple.

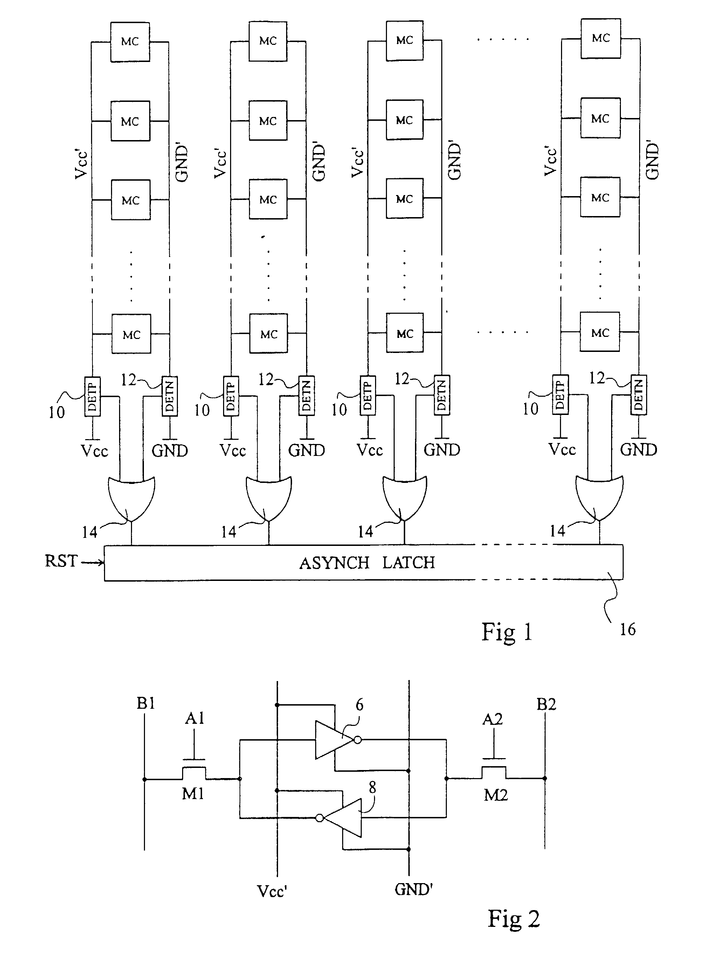

La figure 1 représente schématiquement une mémoire comprenant des cellules mémoire MC disposées en rangées et colonnes, comme cela est classique. Chaque rangée de cellules correspond à un ou plusieurs mots et à des codes de contrôle d'erreur respectivement associés aux mots. Selon l'invention, chaque colonne de cellules est alimentée par des lignes d'alimentation Vcc' et GND' spécifiques.

La figure 2 représente un exemple de cellule de mémoire statique, utilisée dans la mémoire de la figure 1. Cette cellule comprend deux inverseurs 6 et 8 reliés tête-bêche pour former une bascule. Ces inverseurs sont alimentés par des lignes spécifiques Vcc' et GND'. On accède au contenu de la cellule par l'intermédiaire de transistors M1 et M2 reliés respectivement entre une ligne de bit B1 et l'entrée de l'inverseur 6 et entre une ligne de bit B2 et l'entrée de l'inverseur 8. Les transistors M1 et M2 sont commandés par des signaux d'accès respectifs A1 et A2 qui peuvent être respectivment un signal de lecture et un signal d'écriture de la cellule ou, en fonctionnement différentiel, un même signal servant à la fois de signal de lecture et de signal d'écriture.

A la figure 1, chaque ligne spécifique Vcc' est reliée à une ligne d'alimentation générale positive Vcc par l'intermédiaire d'un détecteur de courant respectif (DETP) 10. De même, chaque ligne spécifique GND' est reliée à une ligne d'alimentation générale négative GND, telle qu'une ligne de masse, par l'intermédiaire d'un détecteur de courant respectif (DETN) 12.

Dans de nombreux cas de défaillance, un détecteur de courant sur une seule des lignes d'alimentation spécifiques suffirait car, dans la plupart des cas, le basculement d'une cellule entraîne une consommation de courant sur les deux lignes spécifiques Vcc' et GND'. Toutefois, notamment dans le cas de bombardements d'ions lourds, la consommation de courant sur l'une des lignes spécifiques est notablement plus élevée que dans l'autre. Pour cela, on prévoit de préférence un détecteur de courant par ligne d'alimentation spécifique.

Les sorties des détecteurs de courant 10 et 12 de chaque colonne sont fournies à une porte OU 14. Ainsi, la sortie de la porte 14 devient active lorsqu'au moins un des détecteurs 10 et 12 détecte un courant dans une ligne d'alimentation spécifique. Les sorties des portes 14 sont fournies à un ensemble de bascules asynchrones 16 qui mémorisent la sortie de chacune des portes 14 dès qu'elle devient active.

Avec cette configuration, dès que l'une des bascules 16 devient active, au moins une erreur s'est produite dans l'une des cellules mémoire MC de la colonne correspondante. L'erreur peut avantageusement être détectée dès qu'elle se produit. Pour traiter l'erreur, un microprocesseur associé à la mémoire est par exemple, interrompu par le passage à un état actif de l'une quelconque des bascules 16. Le traitement de l'interruption consiste alors, par exemple, à lire le contenu des bascules 16 pour "marquer" la colonne dans laquelle s'est produite l'erreur puis à lire successivement les mots correspondant à la colonne marquée, avec leurs codes de contrôle. Lorsque le code de contrôle indique une erreur, le bit provenant de la colonne marquée est inversé et le mot ainsi corrigé est réécrit dans la mémoire. A la fin de la procédure de correction, les bascules 16 sont remises à zéro par un signal RST.

La procédure qui vient d'être décrite permet de corriger une erreur pratiquement au moment où elle se produit. Une variante de cette procédure consiste à lire les mots par paquets jusqu'à ce que l'on trouve l'erreur, la tâche courante du microprocesseur étant reprise entre chaque lecture de paquets.

Pour éviter de perdre du temps à chercher l'erreur au moment où elle se produit, la procédure peut être la suivante. L'activation d'une bascule 16 n'entraîne aucune action. Si, en cours d'exécution, un programme lit un mot erroné, il détecte l'erreur à l'aide du code de contrôle. Il vient alors lire le contenu des bascules 16 pour corriger l'erreur.

Si plusieurs erreurs sont survenues simultanément ou successivement sans que l'on ait pu en corriger, on peut arriver à une situation ambiguë où l'on ne peut corriger que certaines d'entre elles ou aucune. Pour cette raison, toute la mémoire doit en pratique être lue afin de vérifier si la situation est ambiguë ou non, avant de procéder à des corrections. Plus le code de contrôle est complet, plus la probabilité de survenue d'une situation ambiguë est faible.

Bien entendu, la correction d'erreurs peut être effectuée par un circuit spécialisé qui arrête tout circuit demandant à accéder à la mémoire tant que la procédure de correction n'est pas terminée.

L'architecture de mémoire selon l'invention permet de corriger des erreurs avec un code de contrôle aussi simple qu'un bit de parité. A l'aide d'un bit de parité, qui ne permet normalement pas de corriger une erreur, l'invention permet de corriger une erreur et même plusieurs erreurs survenues dans une même colonne.

Selon l'invention, avec un code classique correcteur d'erreurs simples et détecteur d'erreurs doubles, on peut, dans le cas général, corriger jusqu'à trois erreurs survenues dans la mémoire, notamment trois erreurs dans un même mot ou trois erreurs dans deux mots. Bien entendu, ce code de contrôle permet, ce qui est son rôle classique, de corriger toutes les erreurs simples des mots.

Si les mots erronés ont deux erreurs chacun dans les mêmes colonnes, ces erreurs peuvent également être corrigées.

L'homme du métier pourra facilement déterminer les cas non ambigus en fonction des indications du code de contrôle utilisé et des bascules 16.

En tout cas, la probabilité pour que plusieurs cellules soient perturbées simultanément est faible. Ainsi, une architecture de mémoire selon l'invention employée avec des bits de parité en tant que codes de contrôle fournit des résultats satisfaisants et constitue un système particulièrement simple.

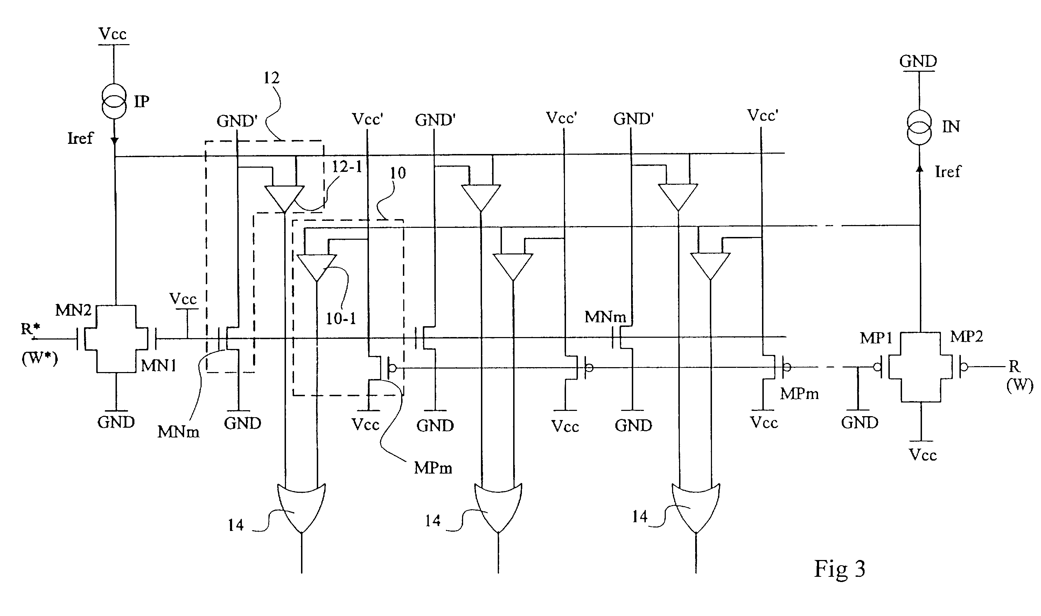

La figure 3 représente de manière détaillée un exemple de structure des détecteurs de courant 10 et 12. Les détecteurs 10 reçoivent une tension de référence générée aux bornes d'un transistor MOS à canal P MP1 relié à la ligne GND par l'intermédiaire d'une source de courant IN et à la ligne Vcc. La grille du transistor MP1 est reliée à la ligne GND, de manière que ce transistor est conducteur et se comporte comme une résistance. De même, les détecteurs 12 reçoivent une tension de référence générée aux bornes d'un transistor MOS à canal N MN1 relié à la ligne Vcc par l'intermédiaire d'une source de courant IP et à la ligne GND. La grille du transistor MN1 est reliée à la ligne Vcc. Les sources de courant IP et IN fournissent un même courant de référence Iref.

Chaque détecteur 10 comprend un transistor MOS à canal P de mesure MPm reliant entre elles les lignes Vcc et Vcc'. La grille du transistor MPm est reliée à la ligne GND. La sortie du détecteur 10 est fournie par un comparateur 10-1 qui compare la tension aux bornes du transistor MPm à la tension seuil aux bornes du transistor MP1. De même, chaque comparateur 12 comprend un transistor MOS à canal N de mesure MNm reliant entre elles les lignes GND et GND'. Un comparateur 12-1 compare la tension apparaissant aux bornes du transistor MNm à la tension seuil aux bornes du transistor MN1. Ainsi, la sortie du comparateur 10-1 ou 12-1 devient active lorsque le courant dans la ligne Vcc' ou dans la ligne GND' dépasse le courant Iref d'un certain facteur déterminé par les rapports de surface des transistors MP1 et MPm, et des transistors MN1 et MNm.

Le seuil de détection déterminé par le courant de référence Iref est choisi suffisamment élevé pour que l'on ne détecte pas intempestivement une consommation de courant normale des cellules mémoire, telle que celle consommée lors d'une lecture ou d'une écriture. En effet, les transistors M1 et M2 de la figure 2 sont alors rendus passants et les inverseurs 6 et 8 doivent délivrer un courant de charge des lignes B1 et B2. Lors d'une écriture la cellule est en outre susceptible d'être basculée.

Toutefois, en augmentant le seuil, on diminue la sensibilité des détecteurs en dehors des phases d'accès en lecture et en écriture.

Pour assurer une bonne sensibilité des détecteurs en dehors des phases d'accès sans toutefois risquer de les déclencher intempestivement pendant les phases d'accès, on augmente le seuil de détection seulement pendant ces phases d'accès. Pour cela, un transistor MN2 est relié en parallèle sur le transistor MN1 et un transistor MP2 est relié en parallèle sur le transistor MP1. Les transistors MP2 et MN2 sont respectivement commandés par un signal de validation en lecture R (ou en écriture W) et par son complément R* (W*). Ainsi, les transistors MP2 et MN2 sont conducteurs en dehors des phases d'accès, ce qui diminue la tension seuil aux bornes des transistors MP1 et MN1, et donc le seuil de détection. Par contre, pendant les phases d'accès, les transistors MP2 et MN2 sont bloqués, ce qui augmente le seuil de détection. On évite ainsi de détecter la seule phase d'accès, mais on détectera une perturbation pendant la phase d'accès, avec pratiquement la même sensibilité qu'en dehors de la phase d'accès.

La présente invention a été décrite en relation avec des phénomènes de perturbation, en particulier des bombardements d'ions lourds, mais elle s'applique à d'autres possibilités d'erreur entraînant une consommation de courant anormale, par exemple lorsqu'une cellule est bloquée à un état par un court-circuit. Dans ce cas, un courant anormal est en permanence détecté. Le mot erroné ne pourra pas être corrigé dans la mémoire, mais il pourra l'être à chaque fois qu'il est lu.

De nombreuses variantes et modifications de la présente invention apparaîtront à l'homme du métier, notamment en ce qui concerne la réalisation des détecteurs 10 et 12 qui peuvent être simplifiés et optimisés de manière à ne consommer aucun courant de repos.

## Revendications

1. Mémoire statique comprenant des cellules mémoire (MC) disposées en rangées et colonnes, chaque rangée de cellules constituant au moins un mot et un code de contrôle d'erreur correspondant, caractérisée en ce que chaque colonne de cellules comprend au moins une ligne d'alimentation spécifique (Vcc', GND') reliée à une ligne d'alimentation générale (Vcc, GND) de la mémoire par l'intermédiaire d'un détecteur de courant (10, 12) qui active un signal d'erreur si le courant de la ligne d'alimentation spécifique dépasse un seuil prédéterminé, la mémoire étant associée à des moyens pour, quand au moins un signal d'erreur est activé, lire des mots de la mémoire et leurs codes de contrôle et, si le code de contrôle d'un mot indique une erreur, corriger le bit du mot dans la colonne correspondant audit au moins un signal d'erreur activé.

2. Mémoire statique selon la revendication 1, caractérisée en ce qu'elle comprend des moyens (MP2, MN2) pour augmenter le seuil prédéterminé de chaque détecteur (10, 12) pendant un accès à la mémoire.

3. Mémoire statique selon la revendication 1, caractérisée en ce que chaque colonne comprend deux lignes d'alimentation spécifiques (Vcc', GND') reliées à deux lignes d'alimentation générale (Vcc, GND) de la mémoire par l'intermédiaire de détecteurs de courant respectifs (10, 12).

4. Mémoire statique selon la revendication 1, caractérisée en ce que le code de contrôle est un bit de parité.

## Patentansprüche

1. Statischer Speicher, welcher in Spalten und Zeilen angeordnete Speicherzellen (MC) aufweist, wobei jede Zeile von Zellen zumindest ein Wort und einen zugehörigen Fehlerkontrollcode bildet, dadurch gekennzeichnet, daß jede Spalte von Zellen zumindest eine spezifische Versorgungsleitung (Vcc', GND') aufweist, welche mit einer allgemeinen Versorgungsleitung (Vcc, GND) des Speichers über einen Stromdetektor (10, 12) verbunden ist, welcher ein Fehlersignal aktiviert, wenn der Strom der spezifischen Versorgungsleitung eine vorbestimmte Schwelle überschreitet, wobei dem Speicher eine Einrichtung zum Lesen der Worte des Speichers und ihrer Kontrollcodes, wenn mindestens ein Fehlersignal aktiviert wird, und, wenn der Kontrollcode eines Wortes einen Fehler anzeigt, Korrigieren des Bits des Wortes in derjenigen Spalte, welche dem besagten zumindest einen aktivierten Fehlersignal entspricht, zugeordnet ist.

2. Statischer Speicher nach Anspruch 1, dadurch gekennzeichnet, daß er eine Einrichtung (MP2, MN2) zum Erhöhen der vorbestimmten Schwelle jedes Detektors (10, 12) während eines Zugriffs auf den Speicher aufweist.

3. Statischer Speicher nach Anspruch 1, dadurch gekennzeichnet, daß jede Spalte zwei spezifische Versorgungsleitungen (Vcc', GND') aufweist, welche mit zwei allgemeinen Versorgungsleitungen (Vcc, GND) des Speichers über entsprechende Stromdetektoren (10, 12) verbunden ist.

4. Statischer Speicher nach Anspruch 1, dadurch gekennzeichnet, daß der Kontrollcode ein Paritätsbit ist.

## Claims

1. A static memory including memory cells (MC) arranged in rows and columns, each row of cells constituting at least one word and one corresponding error control code, characterized in that each column of cells comprises at least one specific supply line (Vcc', GND') connected to a general supply line (Vcc, GND) of the memory through a current detector (10, 12), which activates an error signal if the current of the specific supply line exceeds a predetermined threshold, the memory being associated with means for, when at least one error signal is activated, reading words in the memory with their control codes and, if the control code of a word indicates an error, correcting the bit of the word in the column corresponding to said at least one activated error signal.

2. A static memory according to claim 1, characterized in that it includes means (MP2, MN2) for increasing the predetermined threshold of each detector (10, 12) during a memory access.

3. A static memory according to claim 1, characterized in that each column comprises two specific supply lines (Vcc', GND') connected to two general supply lines (Vcc, GND) of the memory through respective current detectors (10, 12).

4. A static memory according to claim 1, characterized in that the control code is a parity bit.
